# EUROPEAN PATENT APPLICATION

(11) **EP 4 819 807 A1**
(43) Date of publication of application: **07.10.2026**
(21) Application number: 26165500.5
(22) Date of filing: 17.03.2026
(51) Int. Cl.: H10K 59/12, H10K 59/38, H10K 59/80, H10K 71/13

(54) **MANUFACTURING METHOD FOR DISPLAY PANEL AND ELECTRONIC DEVICE INCLUDING THE DISPLAY PANEL**

(30) Priority: 04.04.2025 KR 20250044160
(71) Applicant: Samsung Display Co., Ltd., Yongin-si, Gyeonggi-do (KR)
(72) Inventor: Huh, Myungsoo, Yongin-si, Gyeonggi-Do (KR); Ko, Wooree, Yongin-si, Gyeonggi-Do (KR); Yi, Jeongho, Yongin-si, Gyeonggi-Do (KR)
(74) Representative: Gulde & Partner

(57) **Abstract**

Disclosed is a display panel (DP) manufacturing method which includes a step of providing a preliminary display panel (P-DP) including a base layer (BS) and a display element layer (DP-ED) disposed on the base layer (BS). Barrier walls (BM) are formed and color or scattering solutions (CS1 to CS3, SS) are introduced between the barrier walls (BM) and comprise light scatterers (SP) having a diameter greater than or equal to 0,5 µm and less than or equal to 2 µm.

## Description

### BACKGROUND

Aspects of the present disclosure described herein relate to a method for manufacturing a display panel and an electronic device including the display panel.

Various display modules used in multimedia devices, such as a television, a mobile phone, a tablet computer, and a game machine, are being developed.

Meanwhile, studies on thin display panels are being conducted to implement various types of display panels. However, in the case of a thin display panel excluding a polarization layer, the light emission efficiency may be reduced.

### SUMMARY

Aspects of the present disclosure provide a method for manufacturing a display panel including light scatterers and having improved luminance and light emission efficiency. The disclosure is defined by the appended set of claims. The description that follows is subjected to this limitation. Any disclosure lying outside the scope of said claims is only intended for illustrative as well as comparative purposes.

In particular, according to an aspect of the disclosure, a display panel manufacturing method is provided, which comprises providing a preliminary display panel including a base layer and a display element layer disposed on the base layer. The method further comprises dispensing a light scattering solution through a nozzle onto the preliminary display panel to form a light scattering layer including light scatterers, each of the light scatterers having a diameter greater than or equal to 0,5 µm and less than or equal to 2 µm, the diameter of each of the light scatterers being greater than or equal to 5% and less than or equal to 10% of a diameter of the nozzle. The method further comprises forming a barrier wall on the light scattering layer, the barrier wall having a first and a second barrier wall openings defined therein. The method further comprises dispensing a first and a second color solutions into the first and the second barrier wall openings, respectively, to form a first and a second color filters.

Hence, light scatterers can be easily provided, while color filters can be easily provided in a separate manner, such that the display panel can be manufactured in an easy manner. Further, it may be possible to avoid the necessity for a polarization layer, thereby reducing the thickness of the display panel. Yet, due to the method, light emission efficiency may be improved.

According to an embodiment, forming the barrier wall comprises exposing the light scattering layer with the barrier wall openings. Dispensing the color solutions may comprise dispensing the color solutions in direct contact with the light scattering layer.

An advantage of this embodiment may be that the color solutions can be dispensed without undesired overlap. Still, the color solutions may contact the light scattering layer.

According to an embodiment, the dispensing the light scattering solution is performed by an ink-jetting process.

An advantage of this embodiment may be that ink-jetting or ink-jet printing technology is flexible, precise and cheap.

According to an embodiment, the dispensing the color solutions is performed by an ink-jetting process.

An advantage of this embodiment may be that ink-jetting or ink-jet printing technology is flexible, precise and cheap.

According to an embodiment, the light scattering layer provides a flat upper surface in areas overlapping the first and the second color filters.

An advantage of this embodiment may be that light scattered by the light scattering layer efficiently enters the respective color filter.

According to an embodiment, the light scattering solution has a viscosity greater than or equal to 0,3 Pa*s (3 cps) and less than or equal to 10 Pa*s (100 cps).

An advantage of this embodiment may be that the light scattering solution can be applied easily even into fine structures like the openings or between adjacent walls.

According to an embodiment, at least one of the first or the second color solutions includes a light scatterer or further light scatterers.

An advantage of this embodiment may be that light is scattered by the respective color filter, thereby improving angular color degradation when watching the display panel from an angle, yet, without adding to the thickness of the display panel.

According to an embodiment, the light scattering solution includes an acrylic monomer or a polyimide monomer.

An advantage of this embodiment may be that the light scattering solution is cheap and easily be applied.

According to an embodiment, each of the light scatterers includes one of titanium oxide, zinc oxide, or zirconium oxide.

An advantage of this embodiment may be that the light scatterers scatter light efficiently and/or are cheap.

According to an embodiment, dispensing a light scattering solution includes positioning a dispensing device over the preliminary display panel, the dispensing device comprising the nozzle, a second nozzle, a reservoir and a circulation device. The circulation device may circulate the light scattering solution.

An advantage of this embodiment may be that setting or settling of the light scatterers is avoided or at least reduced, resulting in a more homogenous light scatterers density distribution in the light scattering solution and/or the light scattering layer.

According to an embodiment, the base layer includes a display area and a non-display area adjacent to the display area. The display panel may have a resolution of 80 ppi to 500 ppi in the display area. For example, the display panel may have a resolution of up to 100 ppi, up to 150 ppi, up to 200 ppi, up to 250 ppi, up to 300 ppi, up to 350 ppi, up to 400 ppi or up to 450 ppi.

An advantage of this embodiment may be that display panels with different pixel densities can be provided.

According to another aspect of the disclosure, a display panel manufacturing method is provided, which comprises providing a preliminary display panel including a base layer and a display element layer disposed on the base layer. The method further comprises forming a barrier wall on the preliminary display panel, the barrier wall having a first and a second barrier wall openings defined therein. The method further comprises dispensing a first and a second color solutions into the first and the second barrier wall openings, respectively, to form a first and a second color filters. The method further comprises dispensing a light scattering solution through a nozzle on the first and the second color filters, each of the light scatterers has a diameter greater than or equal to 0,5 µm and less than or equal to 2 µm, the diameter of each of the light scatterers is greater than or equal to 5% and less than or equal to 10% of the diameter of the nozzle.

Hence, light scatterers can be easily provided, while color filters can be easily provided in a separate manner, such that the display panel can be manufactured in an easy manner. Further, it may be possible to avoid the necessity for a polarization layer, thereby reducing the thickness of the display panel. Yet, due to the method, light emission efficiency may be improved.

According to yet another aspect of the disclosure, a display panel manufacturing method is provided, which comprises providing a preliminary display panel including a base layer and a display element layer disposed on the base layer. The method further comprises forming a barrier wall on the display element layer, the barrier wall having a first and a second barrier wall openings defined therein. The method further comprises dispensing through a nozzle a first and a second color solutions into the first and the second barrier wall openings, respectively, to form the first and the second color filters, at least one of the first or the second color solutions includes light scatterers, each of the light scatterers has a diameter greater than or equal to 0,5 µm and less than or equal to 2 µm, the diameter of each of the light scatterers being greater than or equal to 5% and less than or equal to 10% of the diameter of the nozzle.

Hence, light scatterers can be easily provided, while color filters can be easily provided in a separate manner, such that the display panel can be manufactured in an easy manner. Further, it may be possible to avoid the necessity for a polarization layer, thereby reducing the thickness of the display panel. Yet, due to the method, light emission efficiency may be improved.

According to an embodiment, the at least one of the first or the second color solutions including the light scatterers has a viscosity of 0,3 Pa*s (3 cps) to 10 Pa*s (100 cps).

An advantage of this embodiment may be that the respective color solution can be applied easily even into fine structures like the openings or between adjacent walls.

According to an embodiment, the method further comprises, after forming the barrier wall, forming a light scattering layer including light scatterers in at least one of the first or the second barrier wall openings.

An advantage of this embodiment may be that sections of the light scattering layer can be easily separated from each other, e.g. to define pixels or subpixels.

According to an embodiment, the method further comprises, before forming the barrier wall and after the step of providing the preliminary display panel, forming a light scattering layer including light scatterers on the preliminary display panel.

An advantage of this embodiment may be that light is scattered even wider.

According to an embodiment, dispensing the color solutions is performed by an ink-jetting process.

An advantage of this embodiment may be that ink-jetting or ink-jet printing technology is flexible, precise and cheap.

According to an embodiment, dispensing the color solutions comprises dispensing the color solutions in direct contact with the preliminary display panel.

An advantage of this embodiment may be that light can reach the respective color solution directly and without potentially unnecessary loss, improving brightness of the display panel.

According to an embodiment, each of the light scatterers includes one of titanium oxide, zinc oxide, or zirconium oxide.

An advantage of this embodiment may be that the light scatterers scatter light efficiently and/or are cheap.

According to another aspect of the disclosure, any of the methods may comprise omitting a polarization layer.

According to a further aspect of the disclosure, an electronic device is provided, which comprises a display panel, a window disposed on the display panel, and a processor connected with the display panel. The display panel comprises a preliminary display panel including a base layer and a display element layer disposed on the base layer, a light scattering solution on the preliminary display panel and forming a light scattering layer including light scatterers, each of the light scatterers having a diameter greater than or equal to 0,5 µm and less than or equal to 2 µm, a barrier wall on the light scattering layer, the barrier wall having a first and a second barrier wall openings defined therein and a first and a second color solutions in the first and the second barrier wall openings, respectively, and forming a first and a second color filters. Alternatively, the display panel comprises a preliminary display panel including a base layer and a display element layer disposed on the base layer, a barrier wall on the preliminary display panel, the barrier wall having a first and a second barrier wall openings defined therein, a first and a second color solutions in the first and the second barrier wall openings, respectively, forming a first and a second color filters, and a light scattering solution with light scatterers on the first and the second color filters, each of the light scatterers having a diameter greater than or equal to 0,5 µm and less than or equal to 2 µm. Alternatively, the display panel comprises a preliminary display panel including a base layer and a display element layer disposed on the base layer, a barrier wall on the display element layer, the barrier wall having a first and a second barrier wall openings defined therein, and a first and a second color solutions in the first and the second barrier wall openings, respectively, forming the first and the second color filters, at least one of the first or the second color solutions including light scatterers, each of the light scatterers having a diameter greater than or equal to 0,5 µm and less than or equal to 2 µm. For example, the display panel of the electronic device, which comprises the display panel, the window disposed on the display panel, and the processor connected with the display panel, may be manufactured by any of the display panel manufacturing methods disclosed above, e.g. by providing a preliminary display panel including a base layer and a display element layer disposed on the base layer, dispensing a light scattering solution through a nozzle onto the preliminary display panel to form a light scattering layer including light scatterers, each of the light scatterers having a diameter greater than or equal to 0,5 µm and less than or equal to 2 µm, the diameter of each of the light scatterers being greater than or equal to 5% and less than or equal to 10% of a diameter of the nozzle, forming a barrier wall on the light scattering layer, the barrier wall having a first and a second barrier wall openings defined therein, and dispensing a first and a second color solutions into the first and the second barrier wall openings, respectively, to form a first and a second color filters.

Hence, light emission efficiency may be improved, and the display panel may be thin.

Further details of possible embodiments are disclosed in the following.

According to an aspect of the disclosure, a display panel manufacturing method includes a step of providing a preliminary display panel including a base layer and a display element layer disposed on the base layer, a step of forming a light scattering layer including light scatterers on the preliminary display panel, a step of forming a barrier wall having barrier wall openings defined therein on the light scattering layer, and a step of forming first to third color filters by dispensing first to third color solutions into the barrier wall openings.

The step of forming the light scattering layer includes a step of providing a dispensing device including a nozzle over the preliminary display panel and a step of dispensing a light scattering solution through the nozzle. Each of the light scatterers has a diameter of 0,5 µm to 2 µm, and the diameter of each of the light scatterers is greater than or equal to 5% and less than or equal to 10% of the diameter of the nozzle.

The light scattering layer may be exposed by the barrier wall openings, and the first to third color filters may make direct contact with the light scattering layer.

The step of dispensing the light scattering solution may be performed by an ink-jetting process.

The step of forming the first to third color filters may be performed by an ink-jetting process.

The light scattering layer may provide a flat upper surface in an area overlapping the first to third color filters.

At least one of the first to third color solutions may include further light scatterers.

The light scattering solution may include an acrylic monomer or a polyimide monomer.

Each of the light scatterers may include one of titanium oxide, zinc oxide, and zirconium oxide.

The dispensing device may further include a reservoir and a circulation device, the circulation device may circulate the light scattering solution, and the nozzle may be provided in plural.

The light scattering solution may have a viscosity of 3 cps to 100 cps.

The base layer may include a display area and a non-display area adjacent to the display area, and the display panel may have a resolution of 80 ppi to 500 ppi in the display area.

According to another aspect of the disclosure, a display panel manufacturing method includes a step of providing a preliminary display panel including a base layer and a display element layer disposed on the base layer, a step of forming a barrier wall having barrier wall openings defined therein on the preliminary display panel, a step of forming first to third color filters by dispensing first to third color solutions into the barrier wall openings, and a step of forming a light scattering layer including light scatterers on the preliminary display panel. The step of forming the light scattering layer includes a step of providing a dispensing device including a nozzle over the preliminary display panel and a step of dispensing a light scattering solution through the nozzle. Each of the light scatterers has a diameter of 0,5 µm to 2 µm, and the diameter of each of the light scatterers is greater than or equal to 5% and less than or equal to 10% of the diameter of the nozzle.

According to yet another aspect of the disclosure, a display panel manufacturing method includes a step of providing a preliminary display panel including a base layer and a display element layer disposed on the base layer, a step of forming a barrier wall having barrier wall openings defined therein on the display element layer, and a step of forming first to third color filters by dispensing first to third color solutions into the barrier wall openings through a dispensing device including a nozzle.

At least one of the first to third color solutions includes light scatterers. Each of the light scatterers has a diameter of 0,5 µm to 2 µm, and the diameter of each of the light scatterers is greater than or equal to 5% and less than or equal to 10% of the diameter of the nozzle.

Among the first to third color solutions, a color solution including the light scatterers may have a viscosity of 3 cps to 100 cps.

The display panel manufacturing method may further include a step of forming a light scattering layer including the light scatterers in at least one of the barrier wall openings, after the step of forming the barrier wall.

The display panel manufacturing method may further include a step of forming a light scattering layer including the light scatterers on the preliminary display panel, after the step of providing the preliminary display panel and before the step of forming the barrier wall.

The step of forming the first to third color filters may be performed by an ink-jet process.

The first to third color filters may make direct contact with the preliminary display panel.

Each of the light scatterers may include one of titanium oxide, zinc oxide, and zirconium oxide.

According to a further aspect of the disclosure, an electronic device includes a display panel, a window disposed on the display panel, and a processor connected with the display panel. The display panel is manufactured by a display panel manufacturing method including a step of providing a preliminary display panel including a base layer and a display element layer disposed on the base layer, a step of forming a light scattering layer including light scatterers on the preliminary display panel, a step of forming a barrier wall having barrier wall openings defined therein on the light scattering layer, and a step of forming first to third color filters by dispensing first to third color solutions into the barrier wall openings.

The step of forming the light scattering layer includes a step of providing a dispensing device including a nozzle over the preliminary display panel and a step of dispensing a light scattering solution through the nozzle. Each of the light scatterers has a diameter of 0,5 µm to 2 µm, and the diameter of each of the light scatterers is greater than or equal to 5% and less than or equal to 10% of the diameter of the nozzle.

The light scatterers may also be designated as light scattering elements or light scattering particles. The light scatterers may have a diameter greater than or equal to 0,6 µm and less than or equal to 1,9 µm and for example up to 0,7 µm, up to 0,8 µm, up to 0,9 µm, up to 1,0 µm, up to 1,1 µm, up to 1,2 µm, up to 1,3 µm, up to 1,4 µm, up to 1,5 µm, up to 1,6 µm, up to 1,7 µm or up to 1,8 µm. The diameter of each of the light scatterers may be greater than or equal to 6% and less than or equal to 9% and for example up to 7%m or up to 8% of a diameter of the nozzle.

According to another aspect of the disclosure, the display panel may be free from a polarization layer.

An advantage of this embodiment may be that the display panel can be thin.

The unit cps may refer to Centipoise, wherein 1 cps corresponds to 0,1 Pa*s (SI unit for viscosity).

### BRIEF DESCRIPTION OF THE FIGURES

The above and other objects and features of the present disclosure will become apparent by describing in detail aspects thereof with reference to the accompanying drawings.
FIG. 1 is a block diagram of an electronic device according to the present disclosure.
FIG. 2 illustrates schematic views of electronic devices according to various aspects.
FIG. 3 is a perspective view of the electronic device according to an aspect of the present disclosure.
FIG. 4 is an exploded perspective view of the electronic device according to an aspect of the present disclosure.
FIG. 5 is an exploded perspective view of a display module according to an aspect of the present disclosure.
FIG. 6 is a sectional view of the display module taken along line I-I' of FIG. 5.
FIG. 7 is a flowchart illustrating a display panel manufacturing method according to an aspect of the present disclosure.
FIGS. 8A to 8G are views illustrating steps of the display panel manufacturing method according to an aspect of the present disclosure.
FIG. 9 is a flowchart illustrating a display panel manufacturing method according to an aspect of the present disclosure.
FIG. 10 is a sectional view of a display panel manufactured by the display panel manufacturing method of FIG. 9.
FIG. 11 is a flowchart illustrating a display panel manufacturing method according to an aspect of the present disclosure.
FIGS. 12A to 12C are views illustrating steps of the display panel manufacturing method according to an aspect of the present disclosure.
FIG. 13 is a flowchart illustrating a display panel manufacturing method according to an aspect of the present disclosure.
FIG. 14 is a sectional view of a display panel according to an aspect of the present disclosure.

### DETAILED DESCRIPTION

Various changes can be made to the present disclosure, and various aspects of the present disclosure may be implemented. Thus, specific aspects are illustrated in the drawings and described as examples herein. However, it should be understood that the present disclosure is not to be construed as being limited thereto and covers all modifications, equivalents, and alternatives falling within the spirit and scope of the present disclosure.

In this specification, when a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship between components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, aspects of the present disclosure will be described with reference to the accompanying drawings.

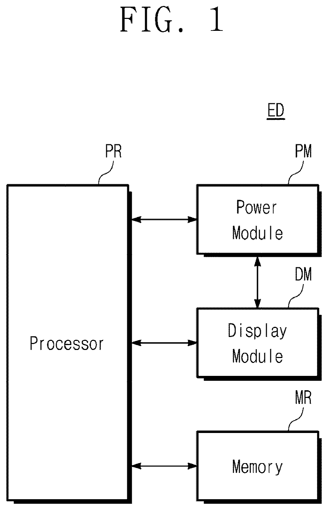

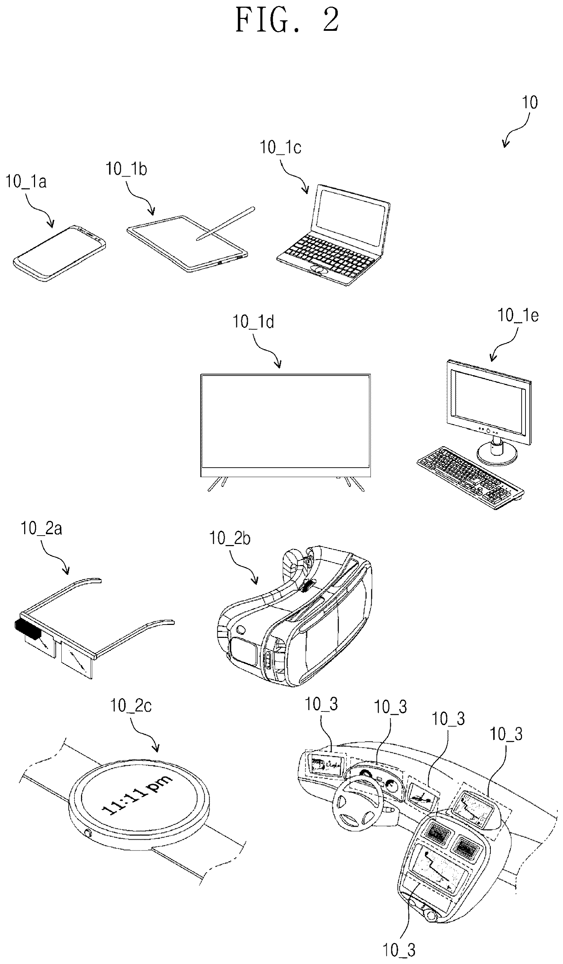

FIG. 1 is a block diagram of an electronic device according to the present disclosure. FIG. 2 illustrates schematic views of electronic devices according to various aspects.

FIG. 1 is a block diagram of an electronic device according to the present disclosure.

The electronic device according to the present disclosure may be provided in various forms. The electronic device according to the present disclosure may further include modules or devices having other additional functions.

Referring to FIG. 1, the electronic device ED according to an aspect may include a display module DM, a processor PR, a memory MR, and a power module PM.

The processor PR may include at least one of a central processing unit (CPU), an application processor (AP), a graphic processing unit (GPU), a communication processor (CP), an image signal processor (ISP), and a controller.

Data information required for operation of the processor PR or the display module DM may be stored in the memory MR. When the processor PR executes an application stored in the memory MR, an image data signal and/or an input control signal may be transferred to the display module DM, and the display module DM may process the provided signal and may output image information through a display screen.

The power module PM may include a power supply module such as a power adapter or a battery device and a power conversion module that converts power supplied by the power supply module and generates power required for operation of the electronic device ED.

Some of the separate modules functionally included in one module may be included in the display module DM, and the others may be provided in the electronic device ED separately from the display module DM.

FIG. 2 illustrates schematic views of electronic devices according to various aspects.

Referring to FIG. 2, the electronic devices according to the various aspects may be not only electronic devices for displaying images, such as a smart phone 10_1a, a tablet PC 10_1b, a laptop computer 10_1c, a TV 10_1d, and a desk monitor 10_1e, but also wearable electronic devices including a display module, such as smart glasses 10_2a, a head mounted display 10_2b, and a smart watch 10_2c, and vehicle electronic devices 10_3 including a display module, such as center information displays (CID) disposed on an instrument panel, a center fascia, and a dashboard of a vehicle and a room mirror display.

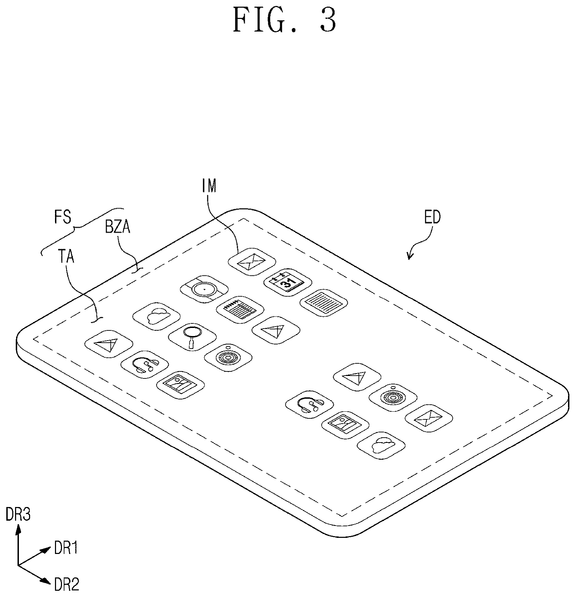

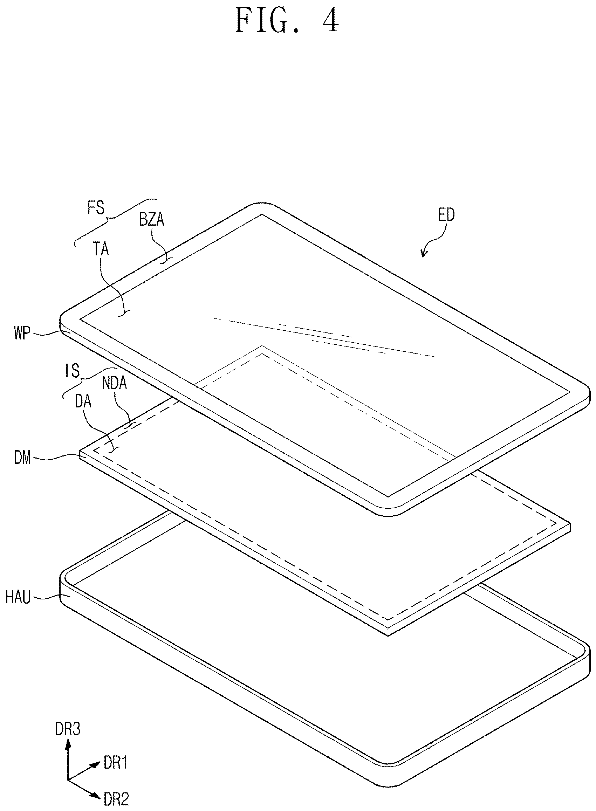

FIG. 3 is a perspective view of the electronic device according to an aspect of the present disclosure. FIG. 4 is an exploded perspective view of the electronic device according to an aspect of the present disclosure.

In this aspect, the electronic device ED, when viewed from above a plane, may have a rectangular shape with short sides extending in a first direction DR1 and long sides extending in a second direction DR2. However, aspects of the present disclosure are not limited thereto, and the electronic device ED may have various shapes such as a circular shape and a polygonal shape.

The electronic device ED may display an image IM in a third direction DR3 through a display surface FS parallel to a plane defined by the first direction DR1 and the second direction DR2. The third direction DR3 may be substantially parallel to the normal direction of the display or front surface FS. The display or front surface FS through which the image IM is displayed may correspond to the front surface of the electronic device ED. The image IM may include a still image as well as a dynamic image. In FIG. 3, icon images are illustrated as an example of the image IM.

In this aspect, front surfaces (or, upper surfaces) and rear surfaces (or, lower surfaces) of members or units may be defined based on the direction in which the image IM is displayed. The front surfaces and the rear surfaces may be opposite each other in the third direction DR3, and the normal directions of the front surfaces and the rear surfaces may be parallel to the third direction DR3. The separation distances between the front surfaces and the rear surfaces that are defined in the third direction DR3 may correspond to the thicknesses of the members (or, the units).

The expression "when viewed from above a plane" used herein may mean that it is viewed in the third direction DR3. The expression "on a cross-section" used herein may mean that it is viewed in the first direction DR1 or the second direction DR2. Meanwhile, the directions indicated by the first to third directions DR1, DR2, and DR2 may be relative concepts and may be changed to other directions.

In the electronic device ED, the display surface FS, through which the image IM is displayed, may correspond to the front surface of the electronic device ED and may correspond to the display or front surface FS of a window WP (refer to FIG. 4). Hereinafter, the display surface and the front surface of the electronic device ED and the front surface of the window WP will be assigned with the same reference numeral. Meanwhile, although not illustrated in the drawings, the electronic device ED may include a foldable display device including a folding area and non-folding areas or a bending display device including at least one bending portion.

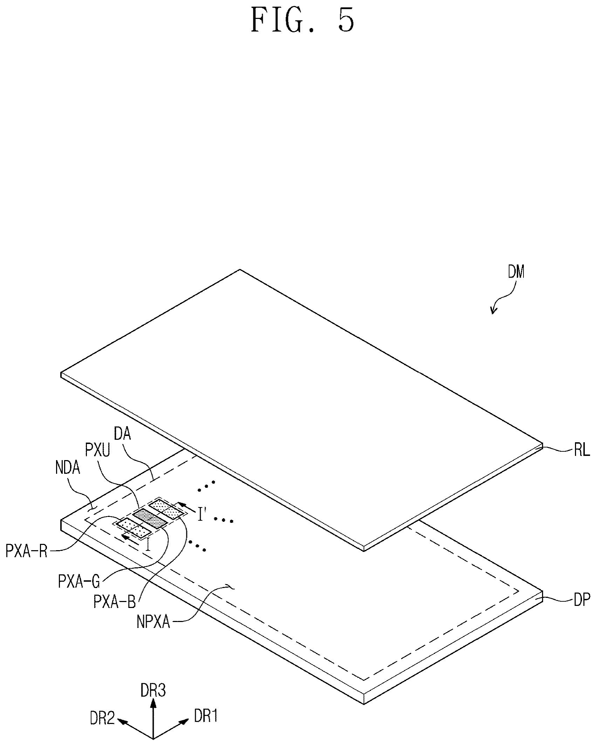

FIG. 4 is an exploded perspective view of the electronic device according to an aspect of the present disclosure. FIG. 5 is an exploded perspective view of a display module according to an aspect of the present disclosure.

Referring to FIG. 4, the electronic device ED according to this aspect may include the window WP, the display module DM, and a housing HAU.

The window WP may include an optically clear insulating material. The window WP may include a transmissive area TA and a bezel area BZA. A user may visually recognize an image provided through the transmissive area TA corresponding to the front surface FS of the window WP.

The transmissive area TA may be an optically clear area. The bezel area BZA may be an area having a lower light transmittance than the transmissive area TA. The bezel area BZA may have a certain color. The bezel area BZA may be adjacent to the transmissive area TA and may surround the transmissive area TA. The bezel area BZA may define the shape of the transmissive area TA. However, aspects are not limited thereto, and the bezel area BZA may be disposed adjacent to only one side of the transmissive area TA or a portion of the bezel area BZA may be omitted.

In FIGS. 3 and 4, the transmissive area TA is illustrated in a quadrangular shape. However, this is illustrative, and the transmissive area TA may have various shapes and is not limited to any one aspect.

The display module DM may be disposed under the window WP. The display module DM may be a component that substantially generates the image IM. The image IM generated by the display module DM is displayed on a display surface IS and visually recognized by the user from the outside through the transmissive area TA.

The display module DM includes a display area DA and a non-display area NDA. The display area DA may be an area activated in response to an electrical signal. The non-display area NDA may be an area covered by the bezel area BZA. The non-display area NDA is adjacent to the display area DA. The non-display area NDA may surround the display area DA.

The housing HAU may accommodate the display module DM. The housing HAU may provide a base space in which the display module DM is disposed. The housing HAU may be disposed to cover the display module DM such that the upper surface, which is the display surface IS of the electronic device ED, is exposed. The housing HAU may cover the side surface and the bottom surface of the display module DM and may expose the entire upper surface. However, aspects are not limited thereto, and the housing HAU may cover not only the side surface and the bottom surface of the display module DM but also a portion of the upper surface.

A display panel DP according to the present disclosure may not include a polarization layer to reduce the overall thickness. In addition, since the display panel DP according to the present disclosure does not include a polarization layer, luminance and light emission efficiency may be improved. The display panel DP according to the present disclosure may use a Mie scattering effect to improve power consumption efficiency.

A display panel manufacturing method in the related art includes a step of forming a light scattering layer to generate the Mie scattering effect. The light scattering layer is subjected to patterning through a "lithography process". However, the light scattering layer includes a light scatterer, and therefore when the lithography process is performed, light for the lithography process is scattered, which causes a defect in the pattern of the light scattering layer. The pattern defect affects the subsequent display panel manufacturing process.

However, according to a display panel manufacturing method according to the present disclosure, a light scattering layer may be formed through an "ink-jetting process", and thus a defect in the pattern of the light scattering layer may be prevented. In addition, according to the display panel manufacturing method according to the present disclosure, the diameter of a light scatterer and the diameter of an ink-jetting nozzle may be optimized to prevent clogging of the nozzle or an accumulation phenomenon. Hereinafter, the manufacturing method of the display panel will be described with reference to the accompanying drawings.

Referring to FIG. 5, the display module DM may include the display panel DP and an anti-reflective layer RL disposed on the display panel DP.

The display panel DP may include a display area DA and a non-display area NDA adjacent to the display area DA. The display panel DP may have a resolution of 80 ppi to 500 ppi in the display area DA.

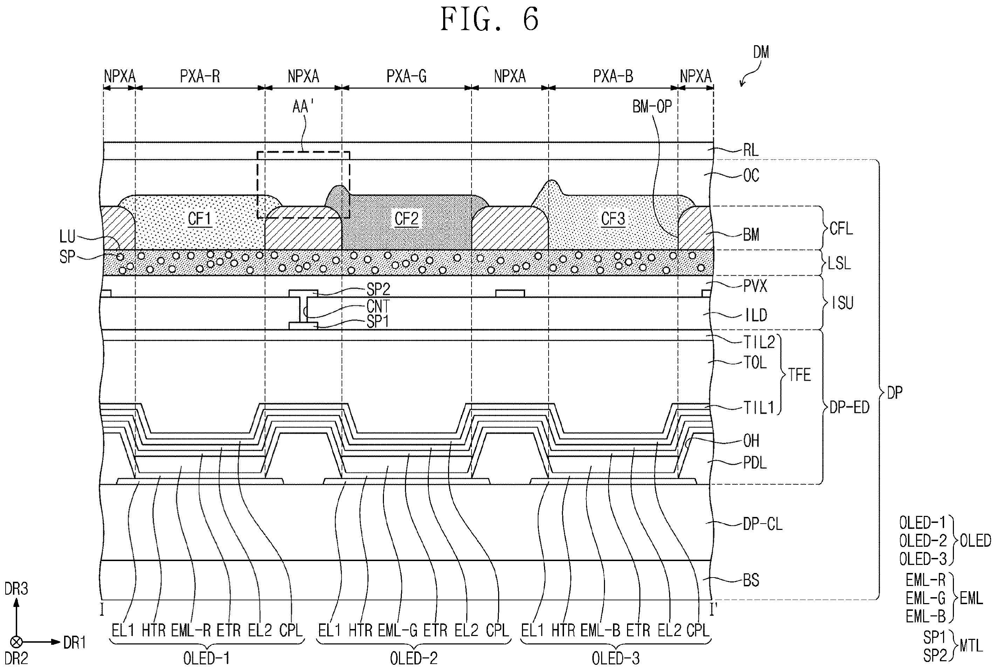

FIG. 6 is a sectional view of the display module taken along line I-I' of FIG. 5.

The display panel DP according to the present disclosure may include a base layer BS, a circuit element layer DP-CL, a display element layer DP-ED, an input sensing layer ISU, a light scattering layer LSL, a color filter layer CFL, and an overcoat layer OC. However, aspects of the present disclosure are not limited thereto, and the input sensing layer ISU and the overcoat layer OC may be omitted as desired.

The base layer BL may provide a base surface on which the circuit element layer DP-CL is disposed. The base layer BL may include a glass substrate, a metal substrate, a polymer substrate, or an organic/inorganic composite substrate.

The circuit element layer DP-CL may be disposed on the display layer BL. The circuit element layer DP-CL may include at least one insulating layer, a circuit element, signal lines, and signal pads. The circuit element layer DP-CL may include a pixel driving circuit included in each of a plurality of pixels for displaying an image and a sensor driving circuit included in each of a plurality of sensors for recognizing external information.

The display element layer DP-ED may be disposed on the circuit element layer DP-CL. The display element layer DP-ED may include a pixel defining layer PDL having pixel openings OH defined therein, light emitting elements OLED disposed in the pixel openings OH, and an encapsulation layer TFE.

The light emitting elements OLED may include a first light emitting element OLED-1, a second light emitting element OLED-2, and a third light emitting element OLED-3. The first light emitting element OLED-1 may emit light of a first color, the second light emitting element OLED-2 may emit light of a second color, and the third light emitting element OLED-3 may emit light of a third color. The first light emitting element OLED-1 may overlap a first light emitting area PXA-R, the second light emitting element OLED-2 may overlap a second light emitting area PXA-G, and the third light emitting element OLED-3 may overlap a third light emitting area PXA-B. In this aspect, the light of the first color may be red light, the light of the second color may be green light, and the light of the third color may be blue light.

The encapsulation layer TFE may be disposed on the pixel defining layer PDL. The encapsulation layer TFE may function to protect the light emitting elements OLED from moisture/oxygen and foreign matter. The encapsulation layer TFE may include a first inorganic encapsulation layer TIL1, an organic layer TOL, and a second inorganic encapsulation layer TIL2.

The input sensing layer ISU may be disposed on the display element layer DP-ED. The input sensing layer ISU may function to sense the user's touch and generate an electrical signal. The input sensing layer ISU may include a sensing insulation layer ILD, a passivation layer PVX disposed on the sensing insulation layer ILD, and a sensing metal layer MTL disposed between the sensing insulation layer ILD and the passivation layer PVX. The sensing metal layer MTL may include a first metal pattern SP1 and a second metal pattern SP2. The first metal pattern SP1 and the second metal pattern SP2 may be connected through a contact hole CNT.

The light scattering layer LSL may be disposed on the input sensing layer ISU. The light scattering layer LSL may be disposed under the color filter layer CFL. The light scattering layer LSL may make direct contact with the color filter layer CFL. The light scattering layer LSL may make the light emitted from the light emitting elements OLED subject to Mie scattering, thereby improving power consumption efficiency and the luminance of the display panel DP. The light scattering layer LSL may include light scatterers SP. The light scattering layer LSL may be formed by an ink-jetting process, the description of which will be given below.

The color filter layer CFL may be disposed on the light scattering layer LSL. The color filter layer CFL may include a barrier wall BM having barrier wall openings BM-OP defined therein and first to third color filters CF1, CF2, and CF3 disposed in the barrier wall openings BM-OP. The first color filter CF1 may transmit red light, the second color CF2 may transmit green light, and the third color filter CF3 may transmit blue light.

The overcoat layer OC may cover the barrier wall BM and the first to third color filters CF1, CF2, and CF3. The overcoat layer OC may make direct contact with the barrier wall BM and the first to third color filters CF1, CF2, and CF3. The overcoat layer OC may be directly disposed on the color filter layer CFL and may simultaneously perform a flattening function and an impact dissipation function.

The anti-reflective layer RL may be disposed on the overcoat layer OC. The anti-reflective layer RL may make direct contact with the overcoat layer OC.

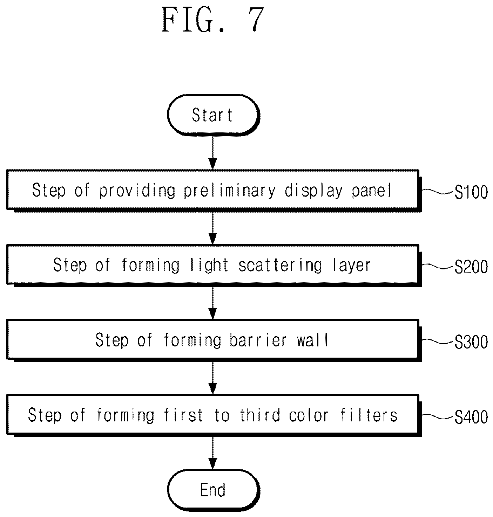

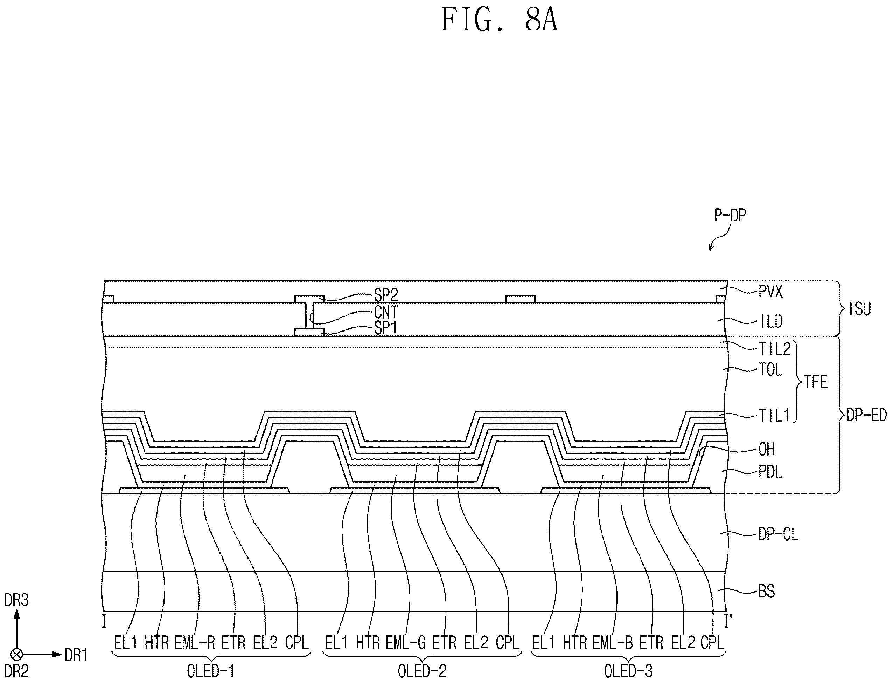

FIG. 7 is a flowchart illustrating a display panel manufacturing method according to an aspect of the present disclosure. FIGS. 8A to 8G are views illustrating steps of the display panel manufacturing method according to an aspect of the present disclosure.

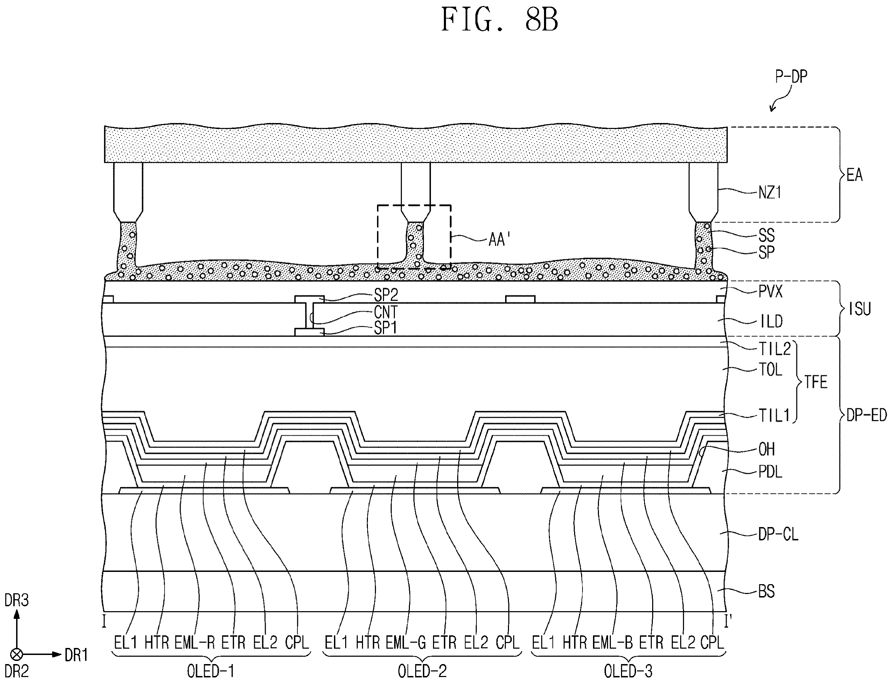

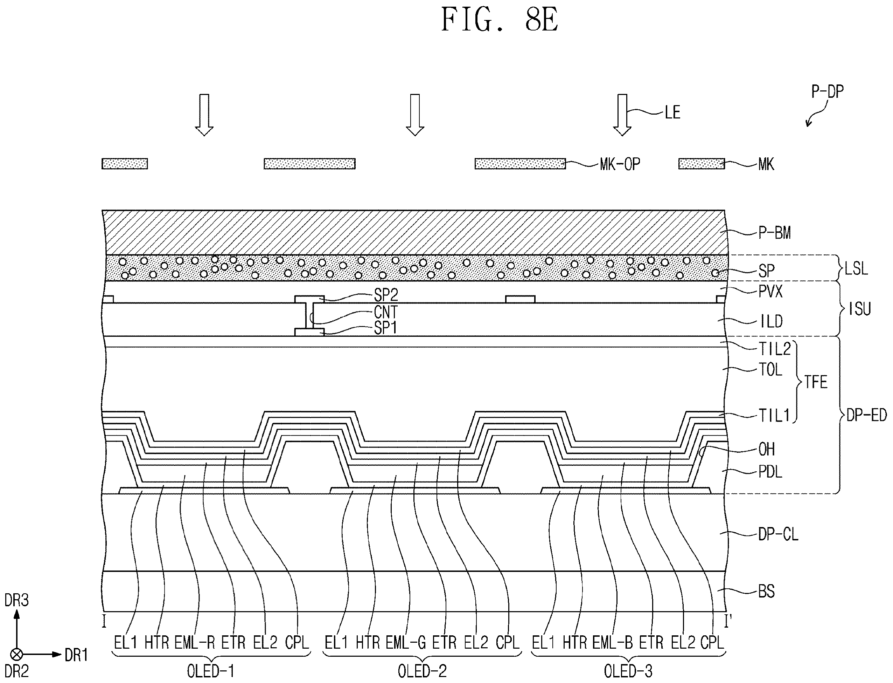

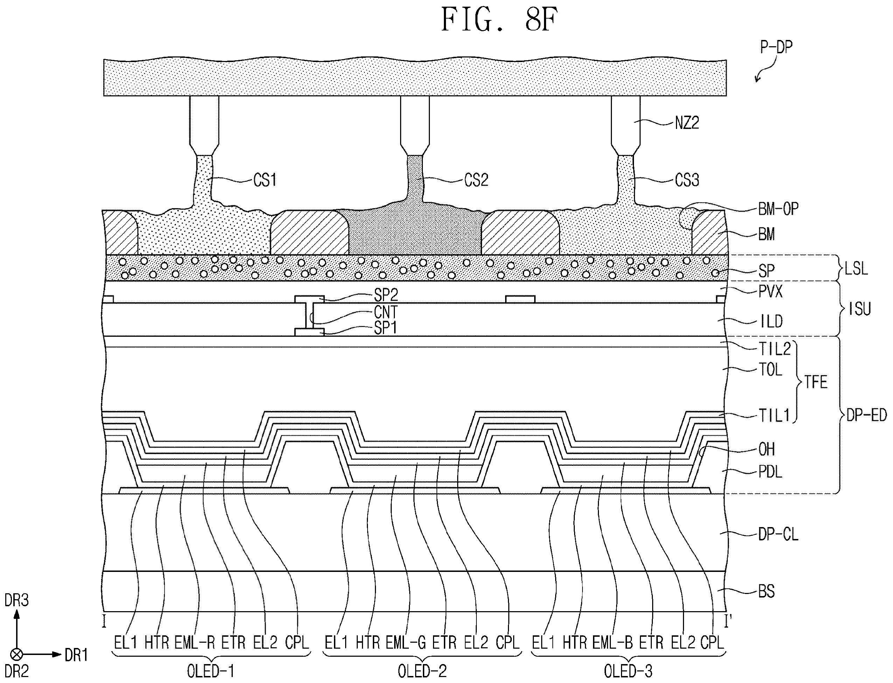

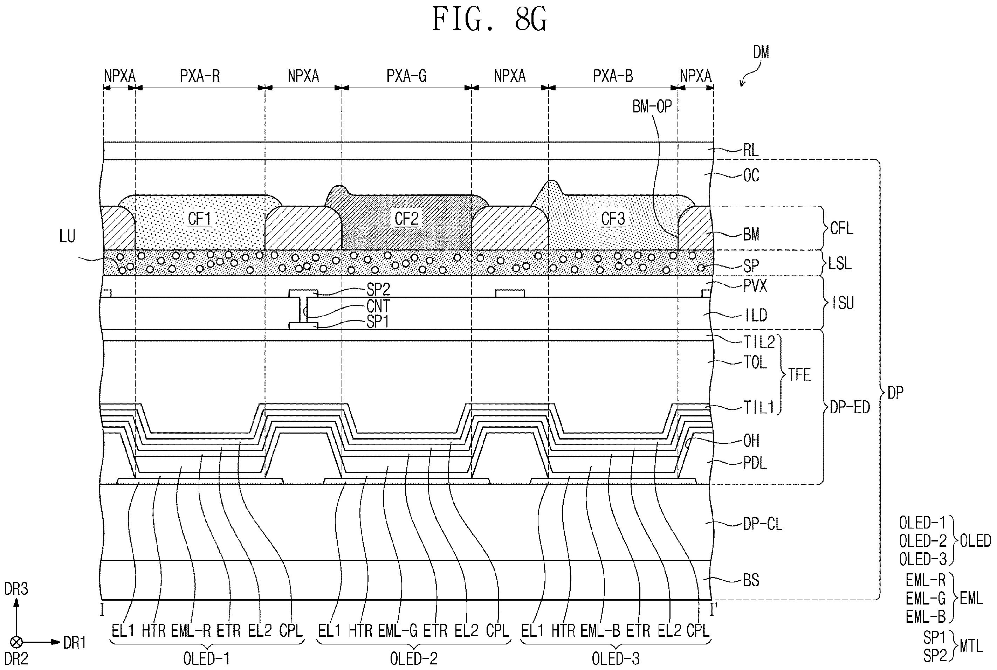

Referring to FIG. 7, the display panel manufacturing method according to the present disclosure may include step S100 of providing a preliminary display panel P-DP (refer to FIG. 8A) including the base layer BS and the display element layer DP-ED (refer to FIG. 8A) disposed on the base layer BS, step S200 of forming the light scattering layer LSL (refer to FIG. 8E) including the light scatterers SP (refer to FIG. 8B) on the preliminary display panel P-DP, step S300 of forming the barrier wall BM (refer to FIG. 8F) having the barrier wall openings BM-OP (refer to FIG. 8F) defined therein on the light scattering layer, and step S400 of forming the first to third color filters CF1, CF2, and CF3 (refer to FIG. 8G) by dispensing first to third color solutions CS1, CS2, and CS3 (refer to FIG. 8F) into the barrier wall openings BM-OP (refer to FIG. 8F).

Referring to FIG. 8A, step S100 (refer to FIG. 7) of providing the preliminary display panel P-DP may be performed. In this specification, the "preliminary display panel P-DP" may be used to collectively refer to a display panel prior to completion in the manufacturing process of the display panel DP. The preliminary display panel P-DP may include the base layer BS, the circuit element layer DP-CL disposed on the base layer BS, the display element layer DP-ED disposed on the circuit element layer DP-CL, and the input sensing layer ISU disposed on the display element layer DP-ED. However, without being limited thereto, the input sensing layer ISU may be omitted.

Referring to FIG. 8B, step S200 (refer to FIG. 7) of forming the light scattering layer LSL (refer to FIG. 6) may be performed. Step S200 of forming the light scattering layer LSL may include a step of providing a dispensing device EA including a nozzle NZ1 over the preliminary display panel P-DP and a step of dispensing a light scattering solution SS through the nozzle NZ1. In this case, the step of dispensing the light scattering solution SS may be performed by an ink-jetting process.

The display panel manufacturing method according to this aspect may form the light scattering layer LSL (refer to FIG. 6) by the ink-jetting process rather than a lithography process, thereby preventing a defect in the pattern of the light scattering layer due to a light scattering phenomenon that occurs in the lithography process.

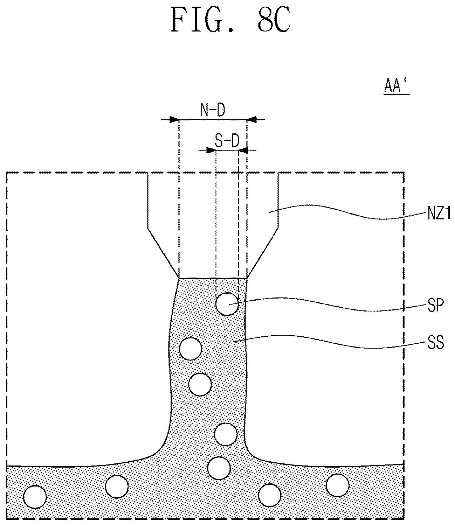

FIG 8C is an enlarged view of area AA' of FIG. 8B.

The light scattering solution SS may be dispensed from the nozzle NZ1 and may be stacked on the preliminary display panel P-DP (refer to FIG. 8B). In FIG. 8C, for convenience of description, the size of the light scatterers SP (refer to FIG. 8B) is exaggerated.

In this aspect, each of the light scatterers SP may have a diameter S-D of 0,5 µm to 2 µm. Since the light scatterers SP have a radius greater than or equal to the wavelength of visible light, a Mie scattering effect may occur in the display panel DP (refer to FIG. 6).

In this aspect, the diameter S-D of each of the light scatterers SP and the diameter N-D of the nozzle NZ1 may form a certain ratio. Specifically, the diameter S-D of each of the light scatterers SP may be greater than or equal to 5% and less than or equal to 10% of the diameter N-D of the nozzle NZ1. When the diameter S-D of each of the light scatterers SP is less than 5% of the diameter N-D of the nozzle NZ1, the light scatterers SP may have an excessively small size and thus may be in an "accumulation" state. Accordingly, the light scatterers SP may not be evenly distributed in the light scattering solution SS, and therefore light scattering efficiency may be reduced. When the diameter S-D of each of the light scatterers SP exceeds 10% of the diameter N-D of the nozzle NZ1, the light scatterers SP may have an excessively large size, and therefore the nozzle NZ1 may become clogged. Accordingly, the efficiency of the display panel manufacturing process may be deteriorated.

The light scattering solution SS may include the light scatterers SP. The light scattering solution SS may include at least one of an acrylic monomer or a polyimide monomer.

Each of the light scatterers SP may include one of titanium oxide, zinc oxide, and zirconium oxide.

The light scattering solution SS may have a viscosity of 3 cps to 100 cps.

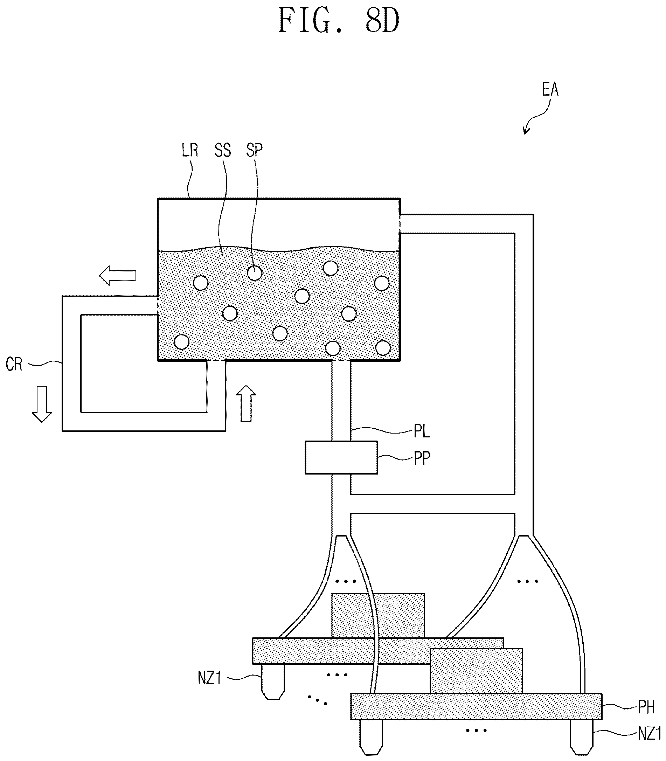

FIG. 8D is a schematic diagram illustrating the structure of the dispensing device EA. Referring to FIG. 8D, the dispensing device EA may include a reservoir LR, a circulation device CR, a pipeline PL, a pump PP, a print head PH, and the nozzle NZ1.

The reservoir LR may provide an inner space in which the light scattering solution SS is stored

The circulation device CR may be a device that consistently circulates the light scattering solution SS to prevent the light scattering solution SS from being accumulated. In FIG. 8D, for convenience of description, the circulation of the light scattering solution SS is illustrated by arrows.

The pump PP may pressurize the light scattering solution SS flowing along the pipeline PL and may move the light scattering solution SS to the print head PH. The print head PH may include the nozzle NZ1. The light scattering solution SS may be dispensed to the outside through the nozzle NZ1. In this aspect, the print head PH may be provided in plural. The manufacturing process of the display panel DP may be made efficient, and the application range may be increased.

Referring to FIG. 8E, step S300 (refer to FIG. 7) of forming the barrier wall BM (refer to FIG. 6) on the light scattering layer LSL may be performed. A preliminary barrier wall P-BM may be formed on the cured light scattering layer LSL. The preliminary barrier wall P-BM may include a black matrix. The preliminary barrier wall P-BM may be subjected to patterning through a lithography process. FIG. 8E illustrates an example where a mask MK having mask openings MK-OP defined therein is disposed over the preliminary barrier wall P-BM and light LE is applied.

Referring to FIG. 8F, step S400 (refer to FIG. 7) of forming the first to third color filters may be performed.

The step of forming the first to third color filters CF1, CF2, and CF3 (refer to FIG. 8G) may be performed by an ink-jetting process.

In the area overlapping the first to third color filters CF1, CF2, and CF3 (refer to FIG. 8G), the light scattering layer LSL may provide a flat upper surface LU (refer to FIG. 6).

The first to third color solutions CS1, CS2, and CS3 may be dispensed into the barrier wall openings BM-OP to form the first to third color filters CF1, CF2, and CF3 (refer to FIG. 8G). The first color solution CS1 may be dispensed into the area overlapping the first light emitting element OLED-1, the second color solution CS2 may be dispensed into the area overlapping the second light emitting element OLED-2, and the third color solution CS3 may be dispensed into the area overlapping the third light emitting element OLED-3.

In this aspect, the light scattering layer LSL may be exposed by the barrier wall openings BM-OP.

Thereafter, referring to FIG. 8G, a step of forming the overcoat layer OC on the color filter layer CFL may be performed.

The first to third color filters CF1, CF2, and CF3 may make direct contact with the light scattering layer LSL.

The anti-reflective layer RL may be formed on the completed display panel DP.

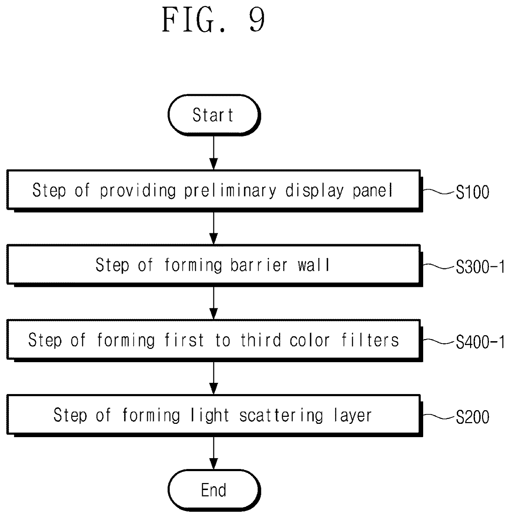

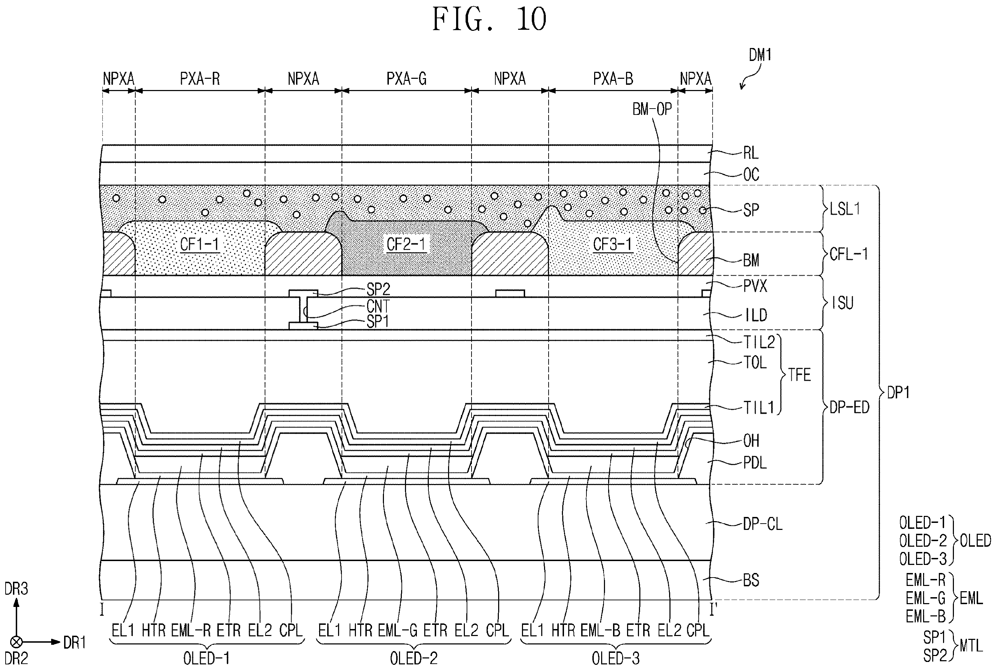

FIG. 9 is a flowchart illustrating a display panel manufacturing method according to an aspect of the present disclosure. FIG. 10 is a sectional view of a display panel manufactured by the display panel manufacturing method of FIG. 9.

Components or steps identical or similar to the components or steps described with reference to FIGS. 1 to 8G will be assigned with identical or similar reference numerals, repetitive descriptions will be omitted, and the following description will be focused on the difference.

Referring to FIGS. 9 and 10, the display panel manufacturing method according to an aspect of the present disclosure may include step S100 of providing a preliminary display panel P-DP including a base layer BS and a display element layer DP-ED disposed on the base layer BS, step S300-1 of forming a barrier wall BM having barrier wall openings BM-OP defined therein on the display element layer DP-ED, step S400-1 of forming first to third color filters CF1-1, CF2-1, and CF3-1 by dispensing the first to third color solutions CS1, CS2, and CS3 (refer to FIG. 8F) into the barrier wall openings BM-OP, and step S200 of forming a light scattering layer LSL1 including light scatterers SP on the first to third color filters CF1-1, CF2-1, and CF3-1. That is, the display panel manufacturing method according to this aspect may form the light scattering layer LSL1 on a color filter layer CFL-1.

The light scattering layer LSL1 may be disposed on the color filter layer CFL-1. The light scattering layer LSL1 may be directly disposed on the color filter layer CFL-1.

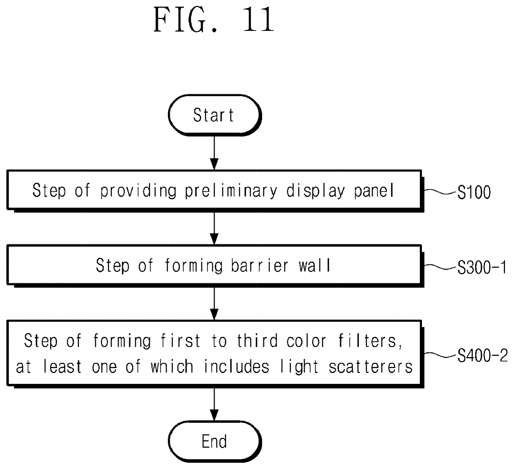

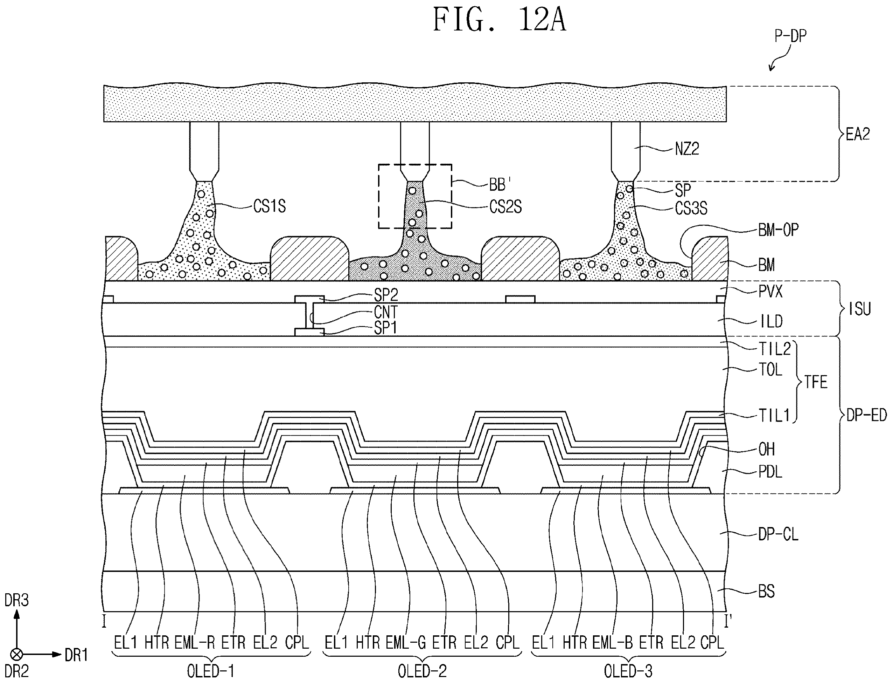

FIG. 11 is a flowchart illustrating a display panel manufacturing method according to an aspect of the present disclosure. FIGS. 12A to 12C are views illustrating steps of the display panel manufacturing method according to an aspect of the present disclosure.

Components or steps identical or similar to the components or steps described with reference to FIGS. 1 to 8G will be assigned with identical or similar reference numerals, repetitive descriptions will be omitted, and the following description will be focused on the difference.

Referring to FIG. 11, the display panel manufacturing method according to an aspect of the present disclosure may include step S100 of providing a preliminary display panel P-DP (refer to FIG. 12A) including a base layer BS and a display element layer DP-ED (refer to FIG. 12A) disposed on the base layer BS (refer to FIG. 12A), step S300-1 of forming a barrier wall BM (refer to FIG. 12A) having barrier wall openings BM-OP (refer to FIG. 12A) defined therein on the display element layer DP-ED (refer to FIG. 12A), and step S400-2 of forming first to third color filters CF1, CF2, and CF3 (refer to FIG. 12A) by dispensing first to third color solutions CS1S, CS2S, and CS3S (refer to FIG. 12A) into the barrier wall openings BM-OP (refer to FIG. 12A) through a dispensing device EA2 (refer to FIG. 12A) including a nozzle NZ2 (refer to FIG. 12A). Unlike the display panel manufacturing method described with reference to FIGS. 7 to 8G, the display panel manufacturing method according to this aspect may not include a separate "step of forming a light scattering layer".

FIG. 12A illustrates step S400-2 (refer to FIG. 11) of forming the first to third color filters which is performed after step S100 of providing the preliminary display panel and step S300-1 (refer to FIG. 11) of forming the barrier wall.

The first to third color solutions CS1S, CS2S, and CS3S may be dispensed into the barrier wall openings BM-OP through the dispensing device EA2 including the nozzle NZ2. Although FIG. 12A illustrates an example that three nozzles NZ2 simultaneously dispensing the first to third color solutions CS1S, CS2S, and CS3S, aspects of the present disclosure are not limited thereto. The first to third color solutions CS1S, CS2S, and CS3S may be dispensed at separate times through separate processes. Step S400-2 of forming the first to third color filters CF1-1, CF2-1, and CF3-1 may be performed by an ink-jetting process.

At least one of the first to third color solutions CS1S, CS2S, and CS3S may include light scatterers SP. Although FIG. 12A illustrates an example that all of the first to third color solutions CS1S, CS2S, and CS3S include the light scatterers SP, aspects of the present disclosure are not limited thereto. The first to third color solutions CS1S, CS2S, and CS3S, including the light scatterers SP may have a viscosity of 3 cps to 100 cps.

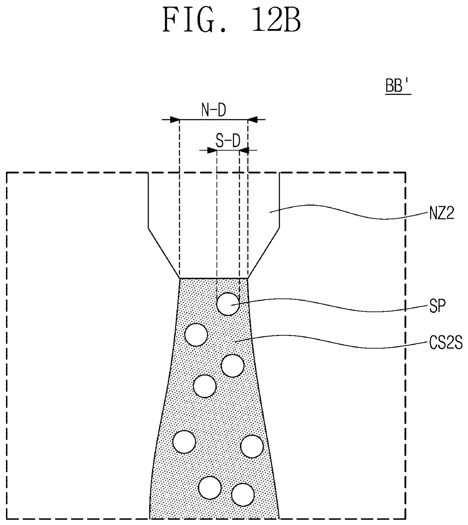

FIG 12B is an enlarged view of area BB' of FIG. 12A.

The first to third color solutions CS1S, CS2S, and CS3S may be dispensed from the nozzle NZ2 and may be stacked on the preliminary display panel P-DP (refer to FIG. 12A). In FIG. 12B, for convenience of description, the size of the light scatterers SP is exaggerated.

Each of the light scatterers SP may have a diameter S-D of 0,5 µm to 2 µm. In this aspect, the diameter S-D of each of the light scatterers SP and the diameter N-D of the nozzle NZ2 may form a certain ratio. Specifically, the diameter S-D of each of the light scatterers SP may be greater than or equal to 5% and less than or equal to 10% of the diameter N-D of the nozzle NZ2.

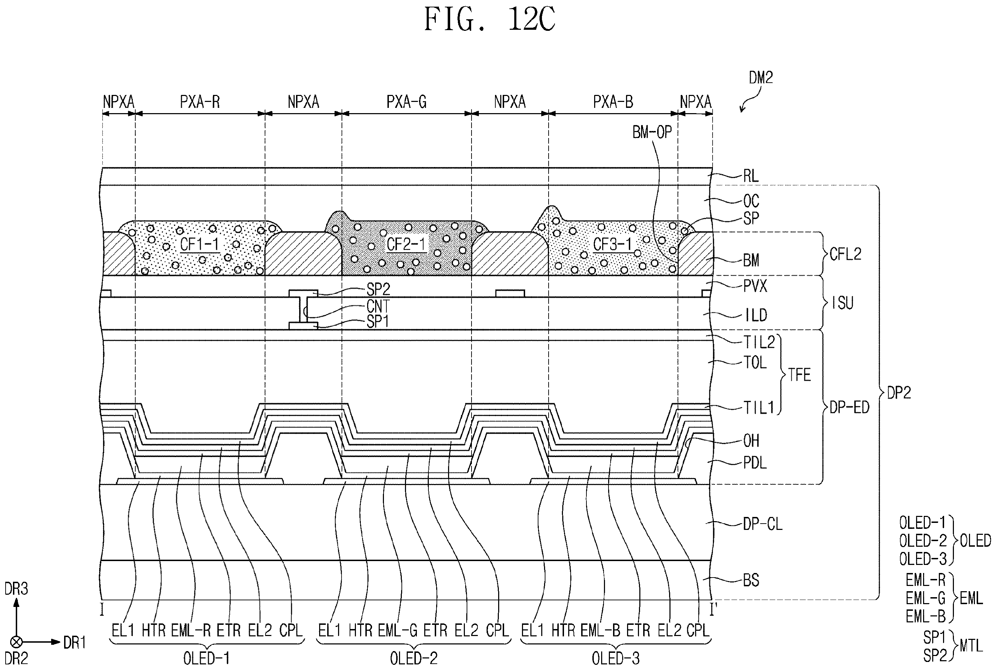

Referring to FIG. 12C, the first to third color filters CF1-1, CF2-1, and CF3-1 may make direct contact with an input sensing layer ISU. When the input sensing layer ISU is omitted, the first to third color filters CF1-1, CF2-1, and CF3-1 may make direct contact with an encapsulation layer TFE.

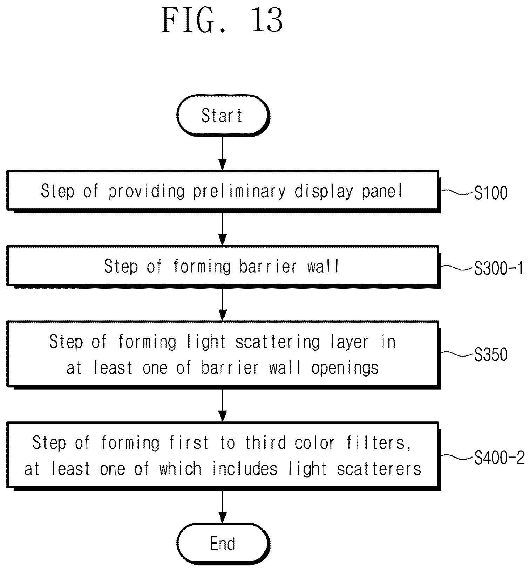

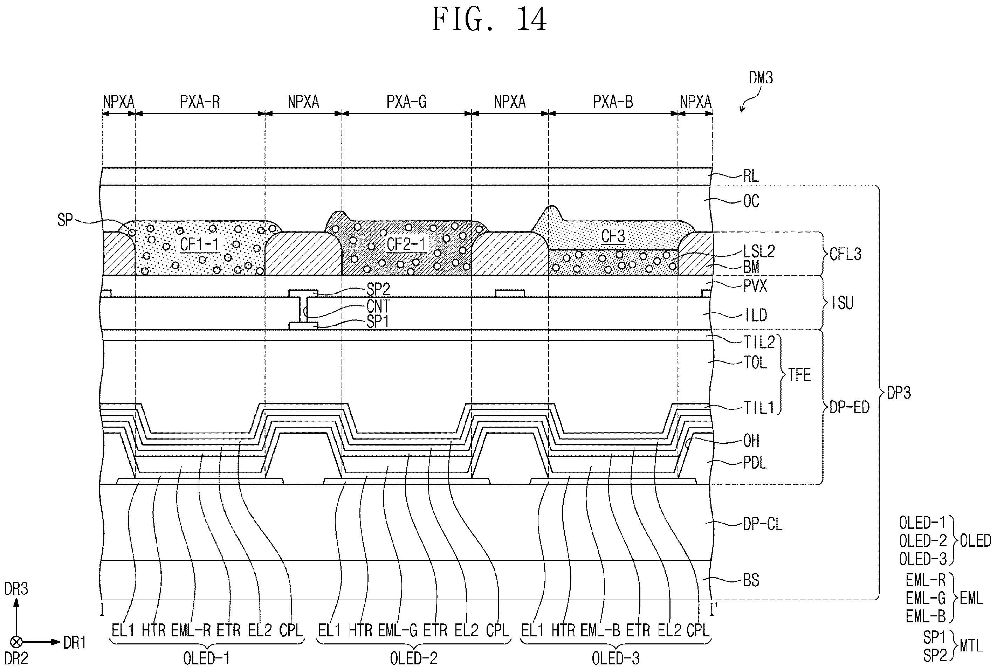

FIG. 13 is a flowchart illustrating a display panel manufacturing method according to an aspect of the present disclosure. FIG. 14 is a sectional view of a display panel according to an aspect of the present disclosure.

The display panel manufacturing method according to an aspect of the present disclosure may include step S100 of providing a preliminary display panel P-DP including a base layer BS and a display element layer DP-ED disposed on the base layer BS, step S300-1 of forming a barrier wall BM having barrier wall openings BM-OP defined therein on the display element layer DP-ED, step S350 of forming a light scattering layer including light scatterers in at least one of the barrier wall openings, and step S400-2 of forming first to third color filters CF1-1, CF2-1, and CF3 by dispensing first to third color solutions CS1S, CS2S, and CS3S into the barrier wall openings BM-OP through a dispensing device EA including a nozzle NZ. When compared to the display panel manufacturing method described with reference to FIG. 11, the display panel manufacturing method according to this aspect may further include the step of forming the light scattering layer including the light scatterers in at least one of the barrier wall openings, after the step of forming the barrier wall.

In this aspect, a portion of the light scattering layer LSL2 may be disposed in the barrier wall opening BM-OP. FIG. 14 illustrates an example that the light scattering layer LSL2 is formed in the barrier wall opening BM-OP overlapping the third light emitting element OLED-3.

The color filter overlapping the light scattering layer LSL2 may not include the light scatterers SP. FIG. 14 illustrates an example where the third color filter CF3 overlaps the light scattering layer LSL2 and does not include the light scatterers SP.

One of the first to third color filters CF1-1, CF2-1, and CF3 may be directly disposed on the light scattering layer LSL2. FIG. 14 illustrates an example that the third color filter CF3 is directly disposed on the light scattering layer LSL2.

The display panel manufacturing method according to this aspect may make the light scattering layer LSL2 subject to patterning through an ink-jetting process and using the barrier wall opening BM-OP as mask openings and thus may form the light scattering layer LSL2 without using a lithography process. Hence, this does not necessarily mean that the barrier wall opening is also formed by an ink-jetting process, although this may be the case. It may, rather, mean that the light scattering layer LSL2 may be formed through an ink-jetting process, and that the barrier wall opening BM-OP, which may be formed above the light scattering layer, may be used to pattern the light scattering layer LSL2. In other words, the barrier wall opening BM-OP may function like a mask in a lithography process, and it may not mean that the barrier wall opening BM-OP itself is formed by an ink-jetting process.

The present disclosure may provide the method for manufacturing the display panel including the light scatterers and having improved luminance and light emission efficiency. In addition, the present disclosure may provide the method for manufacturing the display panel with reduced overall thickness.

While the present disclosure has been described with reference to aspects thereof, it will be apparent to those of ordinary skill in the art that various changes and modifications may be made thereto without departing from the scope of the claims.

## Claims

1. A display panel (DP) manufacturing method comprising:
providing (S100) a preliminary display panel (P-DP) including a base layer (BS) and a display element layer (DP-ED) disposed on the base layer (BS);
dispensing a light scattering solution (SS) through a nozzle (NZ1) onto the preliminary display panel (P-DP) to form (S200) a light scattering layer (LSL) including light scatterers (SP), each of the light scatterers (SP) having a diameter greater than or equal to 0,5 µm and less than or equal to 2 µm, the diameter of each of the light scatterers (SP) being greater than or equal to 5% and less than or equal to 10% of a diameter of the nozzle (NZ1);
forming (S300) a barrier wall (BM) on the light scattering layer (LSL), the barrier wall (BM) having a first and a second barrier wall openings (BM-OP) defined therein; and
dispensing a first and a second color solutions (CS1 to CS3) into the first and the second barrier wall openings (BM-OP), respectively, to form (S400) a first and a second color filters (CF1 to CF3).

2. The display panel (DP) manufacturing method of claim 1, wherein forming (S300) the barrier wall (BM) comprises exposing the light scattering layer (LSL) with the barrier wall openings (BM-OP), and
wherein dispensing the color solutions (CS1 to CS3) comprises dispensing the color solutions (CS1 to CS3) in direct contact with the light scattering layer (LSL).

3. The display panel (DP) manufacturing method of claim 1 or 2, wherein the dispensing the light scattering solution (SS) is performed by an ink-jetting process, and/or wherein the dispensing the color solutions (CS1 to CS3) is performed by an ink-jetting process.

4. The display panel (DP) manufacturing method of any of claims 1 to 3, wherein the light scattering layer (LSL) provides a flat upper surface in areas overlapping the first and the second color filters (CF1 to CF3), and/or wherein the light scattering solution (SS) includes an acrylic monomer or a polyimide monomer, and/or wherein the light scattering solution (SS) has a viscosity greater than or equal to 0,3 Pa*s and less than or equal to 10 Pa*s.

5. The display panel (DP) manufacturing method of any of claims 1 to 4, wherein at least one of the first or the second color solutions (CS1 to CS3) includes further light scatterers (SP).

6. The display panel (DP) manufacturing method of any of claims 1 to 5, wherein dispensing a light scattering solution (SS) includes positioning a dispensing device (EA) over the preliminary display panel (P-DP), the dispensing device (EA) comprising the nozzle (NZ1), a second nozzle (NZ2), a reservoir (LR) and a circulation device (CR), and wherein the circulation device (CR) circulates the light scattering solution (SS).

7. A display panel (DP) manufacturing method comprising:
providing (S100) a preliminary display panel (P-DP) including a base layer (BS) and a display element layer (DP-ED) disposed on the base layer (BS);
forming (S300-1) a barrier wall (BM) on the preliminary display panel (P-DP), the barrier wall (BM) having a first and a second barrier wall openings (BM-OP) defined therein;
dispensing a first and a second color solutions (CS1 to CS3) into the first and the second barrier wall openings (BM-OP), respectively, to form (S400-1) a first and a second color filters (CF1 to CF3); and
dispensing a light scattering solution (SS) with light scatterers (SP) through a nozzle (NZ1) on the first and the second color filters (CF1 to CF3), each of the light scatterers (SP) having a diameter greater than or equal to 0,5 µm and less than or equal to 2 µm, the diameter of each of the light scatterers (SP) is greater than or equal to 5% and less than or equal to 10% of the diameter of the nozzle (NZ1).

8. A display panel (DP) manufacturing method comprising:
providing (S100) a preliminary display panel (P-DP) including a base layer (BS) and a display element layer (DP-ED) disposed on the base layer (BS);
forming (S300-1) a barrier wall (BM) on the display element layer (DP-ED), the barrier wall (BM) having a first and a second barrier wall openings (BM-OP) defined therein; and
dispensing through a nozzle (NZ1) a first and a second color solutions (CS1 to CS3) into the first and the second barrier wall openings (BM-OP), respectively, to form (S400-2) the first and the second color filters (CF1 to CF3), at least one of the first or the second color solutions (CS1 to CS3) includes light scatterers (SP), each of the light scatterers (SP) has a diameter greater than or equal to 0,5 µm and less than or equal to 2 µm, the diameter of each of the light scatterers (SP) being greater than or equal to 5% and less than or equal to 10% of the diameter of the nozzle (NZ1).

9. The display panel (DP) manufacturing method of claim 8, wherein the at least one of the first or the second color solutions (CS1 to CS3) including the light scatterers (SP) has a viscosity of 0,3 Pa*s to 10 Pa*s.

10. The display panel (DP) manufacturing method of claim 8 or 9, further comprising:
after forming the barrier wall (BM), forming a light scattering layer (LSL) including light scatterers in at least one of the first or the second barrier wall openings (BM-OP).

11. The display panel (DP) manufacturing method of any of claims 8 to 9, further comprising:
before forming the barrier wall (BM) and after the step of providing (S100) the preliminary display panel (P-DP), forming a light scattering layer (LSL) including light scatterers (SP) on the preliminary display panel (P-DP).

12. The display panel (DP) manufacturing method of any of claims 8 to 11, wherein dispensing the color solutions (CS1 to CS3) is performed by an ink-jetting process.

13. The display panel (DP) manufacturing method of any of claims 8 to 12, wherein dispensing the color solutions (CS1 to CS3) comprises dispensing the color solutions (CS1 to CS3) in direct contact with the preliminary display panel (P-DP).

14. The display panel (DP) manufacturing method of any of claim 1 to 13, wherein each of the light scatterers (SP) includes one of titanium oxide, zinc oxide, or zirconium oxide.

15. An electronic device (ED) comprising:
a display panel (DP);
a window (WP) disposed on the display panel (DP); and
a processor (PR) connected with the display panel (DP),
wherein the display panel (DP) comprises:
a preliminary display panel (P-DP) including a base layer (BS) and a display element layer (DP-ED) disposed on the base layer (BS);
a light scattering solution (SS) on the preliminary display panel (P-DP) and forming a light scattering layer (LSL) including light scatterers (SP), each of the light scatterers (SP) having a diameter greater than or equal to 0,5 µm and less than or equal to 2 µm;
a barrier wall (BM) on the light scattering layer (LSL), the barrier wall (BM) having a first and a second barrier wall openings (BM-OP) defined therein; and
a first and a second color solutions (CL1 to CL3) in the first and the second barrier wall openings (BM-OP), respectively, and forming a first and a second color filters (CF1 to CF3),
or wherein the display panel (DP) comprises:
a preliminary display panel (P-DP) including a base layer (BS) and a display element layer (DP-ED) disposed on the base layer (BS);
a barrier wall (BM) on the preliminary display panel (P-DP), the barrier wall (BM) having a first and a second barrier wall openings (BM-OP) defined therein;
a first and a second color solutions (CS1 to CS3) in the first and the second barrier wall openings (BM-OP), respectively, forming a first and a second color filters (CF1 to CF3); and
a light scattering solution (SS) with light scatterers (SP) on the first and the second color filters (CF1 to CF3), each of the light scatterers (SP) having a diameter greater than or equal to 0,5 µm and less than or equal to 2 µm,
or wherein the display panel (DP) comprises:
a preliminary display panel (P-DP) including a base layer (BS) and a display element layer (DP-ED) disposed on the base layer (BS);
a barrier wall (BM) on the display element layer (DP-ED), the barrier wall (BM) having a first and a second barrier wall openings (BM-OP) defined therein; and
a first and a second color solutions (CS1 to CS3) in the first and the second barrier wall openings (BM-OP), respectively, forming the first and the second color filters (CF1 to CF3), at least one of the first or the second color solutions (CS1 to CS3) including light scatterers (SP), each of the light scatterers (SP) having a diameter greater than or equal to 0,5 µm and less than or equal to 2 µm.
